# EUROPÄISCHE PATENTANMELDUNG

(11) **EP 3 054 487 A1**
(43) Veröffentlichungstag der Anmeldung: **10.08.2016**
(21) Anmeldenummer: 16153680.0
(22) Anmeldetag: 01.02.2016
(51) Int. Cl.: H01L 31/0232, H01L 31/0352, H01L 31/0384

(54) **OPTOELEKTRONISCHES BAUELEMENTARRAY MIT LICHTLEITERSTRUKTUR**

(30) Priorität: 03.02.2015 DE 102015101515; 14.04.2015 DE 102015105630
(71) Anmelder: Helmholtz-Zentrum Berlin für Materialien und Energie GmbH, 14109 Berlin (DE)
(72) Erfinder: Schmid, Martina, 14059 Berlin (DE); Andrä, Patrick, 12205 Berlin (DE); Manley, Phillip, 12169 Berlin (DE); Lux-Steiner, Martha Christina, 14163 Berlin (DE)

(57) **Zusammenfassung**

Ein derartiges Bauelementearray ist charakterisiert durch eine Lichtleiterstruktur zum Leiten von in das Bauelementearray einfallender elektromagnetischer Strahlung, die mindestens Mittel aufweist, die die Strahlung in laterale Wellenleitermoden koppelt, sowie durch Arrayelemente (4, 4.1, 4.2, 4.3), die benachbart zu den Mitteln, die die Strahlung in horizontale Wellenleitermoden koppeln, angeordnet sind, und jedes Arrayelement (4, 4.1, 4.2, 4.3) mindestens eine aktive Schicht zur Ausbildung eines optoelektronischen Bauelements aufweist, und die Arrayelemente laterale Abmessungen im Nano- bis Mikrometerbereich aufweisen sowie mindestens von wenigstens einem Matrixmaterial (5) ummantelt sind, und durch einen Betrag des Realteils des Brechungsindex der mindestens einen aktiven Schicht, der größer ist als der Betrag des Realteils des Brechungsindex des das jeweilige Arrayelement (4, 4.1, 4.2, 4.3) ummantelnden Matrixmaterials (5), wobei dieses Verhältnis der beiden Brechungsindizes in einem Abstand von der Lichtleiterstruktur bis mindestens der Abklinglänge der Felder der lateralen Wellenleitermoden gilt.

## Beschreibung

Die Erfindung betrifft ein optoelektronisches Bauelementearray mit Lichtleiterstruktur.

Für die Übertragung elektromagnetischer Strahlung sind dem Stand der Technik nach allgemein Lichtleiteranordnungen bekannt, die verschiedene Komponenten, beispielsweise für die Konzentration, das Ein- und Auskoppeln und die Führung der Strahlung, umfassen können. Diese Komponenten dienen dazu, die einfallende elektromagnetische Strahlung gezielt auf einen Empfänger ganz unterschiedlicher Art zu richten.

Folgende Veröffentlichungen seien als Beispiele für Lichtleiterstrukturen genannt.

In DE 10 2006 016 957 A1 ist ein Laserapplikator mit einem Katheter beschrieben, der eine Lichtleitstrecke enthält und am distalen Ende einen lateralen Auskopplungsbereich aufweist. Damit ist eine linienförmige Einleitung der Laserenergie in das Körpergewebe möglich. Um eine bestimmte Strahlungsintensität am Behandlungsort zu erreichen, können beispielsweise zusätzliche Materialien eingebracht werden, wie z.B. SiO₂-Nanopartikel in einen Kunststoff, so dass sich der Brechungsindex in axialer Richtung verändert, oder sind Stufenauskoppler vorgesehen, die eine stufenweise Teilauskopplung der Laserenergie bewirkt. Eine Regelung der austretenden Strahlungsenergie kann aber auch mittels Reflexion bzw. Absorption im Fasermaterial der Lichtleitstrecke erfolgen.

Das in US 2010/ 0 288 352 A1 beschriebene lichtkonzentrierende Bauelement weist ein Array von Nano-Öffnungen auf. Diese Nanoarray-Schicht ist benachbart zu einer Wellenleiterschicht angeordnet, die das über die Nanoarray-Schicht einfallende Licht zu einer am Ende der Wellenleiterschicht angeordnete Solarzelle führt.

Bei dem in DE 10 2010 014 631 A1 beschriebenen photovoltaischen Konzentratormodul, basierend auf einer Mehrfach-Solarzelle, wird eine Frequenzänderung von Teilen des einfallenden Lichts mittels eines Up- bzw. Down-Conversion-Materials beschrieben. Dieses Material befindet sich in einer optischen Komponente, die vor dem aktiven Bauelement angeordnet ist. Mit der Frequenzänderung werden die Schwankungen des Sonnenlichts vor Einspeisung in das aktive Bauelement verringert.

Der in US 2010/ 0 126 566 A1 beschriebene Wellenlängen-Konverter weist in einer wellenlängenkonvertierenden Schicht aus einem Up- bzw. Down-Conversion-Material Zentren - beispielsweise aus einem Polymer - auf. Benachbart zu der wellenlängenkonvertierenden Schicht, in die die Zentren eingebettet sind, ist eine Schicht angeordnet, die nanoskalige Öffnungen aufweist.

In FR 2 996 356 A1 ist ein optoelektronisches Bauelement mit einer Vielzahl von Arrayelementen beschrieben, wobei jedes Arrayelement als photovoltaisches Bauelement ausgebildet ist. Diese photovoltaischen Bauelemente sind in eine Schicht aus transparentem Material eingebettet. Eine in Richtung des einfallenden Sonnenlichts, d.h. oberhalb der Arrayelemente angeordnete Schicht, konvertiert die Wellenlängen des einfallenden Sonnenlichts in die Wellenlängen, für die die photovoltaischen Bauelemente ausgebildet sind.

Über eine Photokatalyseeinrichtung mit einem Lichtelement und einer auf dem Lichtelement angeordneten photokatalytischen Substanz wird in DE 10 2009 044 926 A1 berichtet. Dabei sind entlang der äußeren Mantelfläche einer brechwertangepassten Lichtleitfaser Streuzentren und die photokatalytische Schicht angeordnet. So kann gezielt Licht aus der Lichtleitfaser durch diese Streuzentren ausgekoppelt werden. Das seitenemittierte Licht trifft dann auf die - ebenfalls auf der äußeren Mantelfläche der Lichtleitfaser angeordnete - photokatalytische Substanz und regt diese zur Bildung eines Elektron-Loch-Paares an. Die Streuzentren in dieser Anordnung sind Gebilde gleich welcher Form, welchen Materials und/oder welcher Größe, die das geleitete Licht streuen können. Damit wird das auftreffende Licht abgelenkt, so dass es die Lichtleitfaser gerichtet in ihre Umgebung - hier die photokatalytische Substanz - verlassen kann.

Bei der in US 8 412 010 B2 beschriebenen Anordnung wird Licht mittels Linsen in einen unterteilten und gestuften Wellenleiter eingekoppelt. Aufgrund der verschiedenen Fokii der Linsen wird konzentriertes und spektral ausgewähltes Licht zu einem Empfänger - hier eine Solarzelle - geführt. Die Solarzelle ist am Ende des Wellenleiters angeordnet.

In US 2012/0056081 A1 ist eine Lichtführung beschrieben, bei der Mikrofluide als Wellenleiter bzw. Einkoppeloptik verwendet werden. Ein fokussierter Strahl trifft auf einen flüssigen Wellenleiter, der das Licht in optisch aktive Schichten auskoppelt.

Für die effektive Nutzung der Sonnenenergie, d.h. ihrer Umwandlung in elektrische Energie, werden weiter Lösungen für photovoltaische Bauelemente gesucht, die z. B. eine kostengünstige Herstellung ermöglichen, materialsparend sind oder ein neues Design in der Bauelemente-Anordnung für eine effiziente Umwandlung bzw. Verbesserungen in der optischen Führung und im Lichtmanagement des einfallenden Sonnenlichts aufweisen.

Zur Materialeinsparung wurden Dünnschichtbauelemente vorgeschlagen, die - kombiniert in photovoltaischen Bauelementen mit Mehrfachübergängen (multijunctions) - der besseren Ausnutzung des Sonnenlichts dienen. Zur Erhöhung der Photonendichte sind beispielsweise Konzentratoreinrichtungen für Solarzellen, wie Nanopartikel, bekannt, die - aufgebracht auf bestimmte Schichten einer photovoltaischen Anordnung - gezielt das einfallende Sonnenlicht in diese Schicht einkoppeln.

Nanopartikel sind bereits zur Verbesserung der Effizienz verschiedenartiger Solarzellen seit einigen Jahren von Interesse. Begründet ist dies durch ihre Eigenschaften: der Konzentration des Lichts in ihrer Umgebung (durch die Verstärkung des auftretenden Nahfeldes kommt es zur verstärkten Absorption des Lichts in dem die Nanopartikel umgebenden Medium), der richtungssteuerbaren Streuung und der Einkopplung in Wellenleitermoden (verstärkte Einkopplung des gestreuten Lichts in dünne Schichten führt zu einer Erhöhung der effektiven Weglänge und zu Lichteinfang - light trapping).

In NANOSCALE RESEARCH LETTERS 2014, 9:50, wird über das Absorptions- und Streuverhalten verschiedener Materialien berichtet.

In NATURE MATERIALS, vol. 11, March 2012, 174-177, werden verschiedene Konzepte für ein Lichtmanagement in hocheffizienten photovoltaischen Bauelementen vorgestellt. U.a. ist eine Oberflächen-Nanostruktur beschrieben, wobei die Lichtführung in dünne Halbleiterschichten durch Nahfeldeffekte und Wellenleitermoden beschrieben wird.

Zur Verbesserung der Absorption des Sonnenlichts in einer Dünnfilm-Photovoltaik-Solarzelle wurde u.a. 2007 in JOURNAL OF APPLIED PHYSICS, Vol. 101, 093105, 2007 die Verwendung von metallischen Nanopartikeln vorgeschlagen. Beschrieben ist beispielsweise eine Silizium auf Isolator-Anordnung (Silicon on Insulator - SOI-Anordnung) bzw. eine waferbasierte 300 µm planare Siliziumzelle. Beide Anordnungen weisen auf der aktiven Schicht eine etwa 30 nm dicke Oxidschicht auf. Diese Oxidschicht hat die Funktion einer Passivierungsschicht, auf der sich metallische Nanopartikel befinden und deren Dicke sehr stark die Kopplung zwischen der aktiven Si-Schicht und den Plasmonen (Schwingungsquant der Plasmawellen) beeinflusst. Silber wurde wegen seiner geringen Absorptionsverluste im Vergleich mit anderen Metallen ausgewählt. Es wird beschrieben, dass erst ab einer bestimmten Größe der Partikel die Streueigenschaften dominieren, während bei kleineren Partikeln die Absorption überwiegt.

In JOURNAL OF PHOTONICS FOR ENERGY, vol. 5, 2015, 057003, wird über Simulationen berichtet, die die Wirkung von Nano- und Mikrolinsen - konkret von metallischen und dielektrischen Nano- und Mikropartikeln - für die Fokussierung des einfallenden Lichts auf Solarzellen beschreibt. In metallischen Nanopartikeln werden plasmonische Effekte bei Lichteinfall hervorgerufen, dielektrische Nanopartikel führen zu einer starken Vorwärtsfokussierung des einfallenden Lichts. Diese Eigenschaften werden bei der Führung des einfallenden Lichts zu photovoltaischen Bauelementen ausgenutzt. Es wird festgestellt, dass die Brennweite der Linsen abhängig ist von ihrer Größe, dem Brechungsindex des Substrats, in das eingekoppelt werden soll, und der Form der Nano- und Mikropartikel.

In Solar Energy Materials & Solar Cells 94 (2010) 1481-1486 wird u.a. darüber berichtet, dass die Streuung des einfallenden Lichts auch für andere Halbleitermaterialien außer Silizium ausgenutzt wird, so z.B. in InP/InGaP-Quantenpunkt-Solarzellen und in GaAs-Solarzellen. Weitere Untersuchungen für den Einsatz von Nanopartikeln wurden auch für die Ausbildung von Tandemzellen berichtet, wobei Bereiche der aktiven Schicht unterschiedliche Halbleitermaterialien mit unterschiedlichen Bandlücken und/oder unterschiedlich großen Nanopartikeln aufweisen.

In Nanotechnology 22 (2011) 025204 wird ein eindimensionales optisches Modell vorgestellt, das sowohl die Plasmonenstreuung als auch die Dünnschicht-Optik bei der Simulation optischer Eigenschaften von metallische Nanoteilchen aufweisenden Dünnfilm-Solarzellen berücksichtigt. Es werden Simulationsergebnisse für unterschiedliche Nanostrukturen in unterschiedlichen Positionen einer Solarzellenstruktur beschrieben.

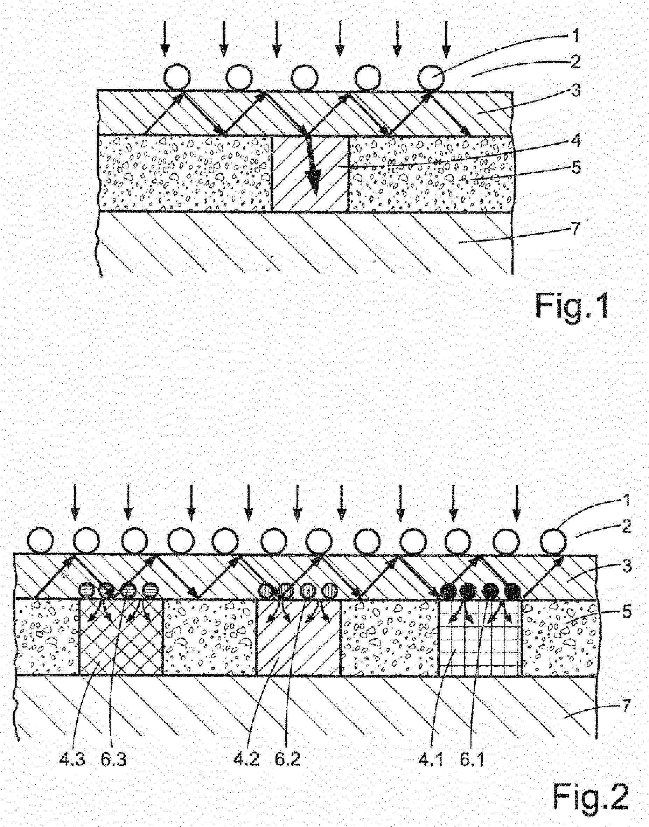

Bei der in NATURE MATERIALS, Vol. 9, March 2010, 205-213 vorgestellten Figur 2b dienen metallische Nanopartikel als sub-Wellenlängen-Antennen, durch die das plasmonische Nahfeld in das Halbleitermaterial eingekoppelt wird, wodurch der effektive Absorptionsquerschnitt vergrößert wird. Die Einkopplung erfolgt hierbei flächig in die aktive Schicht. In dieser Veröffentlichung sind auch plasmonische Tandem-Solarzellen beschrieben, bei denen Halbleiterschichten mit unterschiedlicher Bandlücke übereinander angeordnet sind, getrennt durch eine metallische Kontaktschicht mit jeweils unterschiedlichen plasmonischen Nanostrukturen, die unterschiedliche Wellenlängen des Sonnenlichts in die entsprechende Halbleiterschicht einkoppeln.

Der in US 2009/0250110 A1 beschriebene Photodetektor weist auf einer pin-Silizium-Struktur eine 20 nm dicke ITO-Schicht als transparente Frontelektrode auf, auf der Gold-Nanopartikel aufgebracht sind. Die Nanopartikel sind dabei in einer solchen Dichte angeordnet, dass eine Vorwärtsstreuung des einfallenden Lichts, also Streuprozesse, bei denen es nur zu einer kleinen Ablenkung kommt, d. h. nur ein kleiner Streuwinkel auftritt, realisiert wird. Die Streuung erfolgt dabei von den Nanopartikeln durch die Frontelektrode in die pin-Silizium-Struktur. Die Absorption in einem derartigen Bauelement wird durch Ausnutzung des dielektrischen Verhaltens der metallischen oder anderer Nanostrukturen bei Wellenlängen im sichtbaren und nahe dem sichtbaren Wellenlängenbereich erhöht, um so die Durchlässigkeit von Photonen in das aktive Halbleitergebiet zu verbessern. Damit kann die Photostromerzeugung verbessert werden, und der Wirkungsgrad der Energieumwandlung erhöht sich. Über die Struktur und die Zusammensetzung der Nanopartikel kann der Wellenlängenbereich für die Realisierung des beschriebenen Effektes eingestellt werden. Dabei ist zu beachten - wie bereits erwähnt -, dass für kleiner werdende Durchmesser der Nanopartikel in Abhängigkeit vom Material die Absorption überwiegt und die Streuung verringert wird.

In EP 2 109 147 A1 ist eine photovoltaische Zelle beschrieben, die eine metallische, fingerähnliche Struktur in nm-Abmessungen zur Erzeugung von Plasmonenresonanzen aufweist, um resonant das einfallende Licht in die Absorptionsschicht einzukoppeln und die photo-induzierten Ladungsträger aus der Absorptionsschicht wegzutransportieren - ohne hierfür eine hochdotierte Oberfläche der Emitterschicht ausbilden zu müssen. Entlang eines Metallfingers kann der Brechungsindex geändert werden, wodurch die transparenten und die streuenden Bereiche in ihrer Größe jeweils für ein bestimmtes Spektrum zur Einkopplung des einfallenden Lichts in die Halbleiterschicht optimiert werden. Zusätzlich zu den nm-großen Metallfingern wird weiterhin vorgeschlagen, zwischen diesen Nanostrukturen aufzubringen, die die resonante Streuung durch Plasmonen zur Lichteinkopplung in den Halbleiter unterstützen. Besonders geeignet sind hierfür zylinderförmige oder halbkugelförmige Nanostrukturen.

Bei der in US 2007/0289623 A1 beschriebenen Anordnung zu Fig. 2b enthält die plasmonische photovoltaische Struktur eine aus Quantenpunkten gebildete aktive Schicht. Eine plasmonische photovoltaische Zelle mit Mehrfachübergangen, die mehrere aktive Schichten mit unterschiedlichen Bandlücken (mit dem Lichteinfall abnehmend) aufweist, ist ebenfalls beschrieben.

Neben vertikalen Solarzellen mit Mehrfachübergängen, wobei zwei bis drei pn-Übergänge übereinander angeordnet sind, wird in https://gcep.stanford.edu/pdfs/factsheets/wong solar 07.pdf (abgerufen: 2015-01-22) auch eine Solarzelle mit Mehrfachübergängen beschrieben, bei der Subzellen - basierend auf Nanodrähten - parallel verbunden sind, wobei die einfallende Strahlung durch eine plasmonische Anordnung gefiltert und lateral verteilt wird. Dieses Bauelement weist sowohl Eigenschaften eines lateralen Spektralfilters als auch Eigenschaften eines Lichtkonzentrators auf. Die Nanostruktur ist hierbei direkt auf dem Nanodraht lokalisiert, d.h. es ist technologisch eine Ausrichtung der Nanostruktur auf dem Nanodraht zu realisieren.

In US 2012/006913 A1 ist ein Bauelement zur Umwandlung von Sonnenenergie in elektrische Energie beschrieben, das Nanostrukturen (speziell beschrieben sind kugelförmige) auf einer TiO₂-Schicht aufweist, die benachbart zu einer halbleitenden flächigen Absorberschicht angeordnet ist.

In der Doktorarbeit von Antti Pennanen (2013) abrufbar unter http://www.jyu.fi/static/fysiikka/vaitoskirjat/2013/Pennanen-Antti-FL-2013 (abgerufen: 2015-01-22, s. S. 15 f.) wird eine plasmonengestützte Dünnfilm-Solarzelle beschrieben, die als Lichteinfangstrukturen Nanopartikel auf der aktiven Schicht aufweist. Weiterhin sind derartige Lichteinfangstrukturen auch auf dem Rückseitenreflektor oder eine Oberflächentextur ist auf der dem Lichteinfall zugewandten Oberfläche der Solarzelle beschrieben. Dabei wird das Licht, das in den Nanopartikeln eingefangen wird, bevorzugt in das Medium mit dem höheren Brechungsindex eingekoppelt. Eine Anordnung der Nanopartikel auf der Rückseite wird ebenfalls vorgeschlagen, um so die Verluste, die durch die Absorption des einfallenden Lichts in den Nanopartikeln auftreten können, zu verringern. Bei einer derartigen Anordnung wird das eingekoppelte Licht seitlich aus der Anordnung herausgeführt.

Aufgabe der Erfindung ist es, ein optoelektronisches Bauelementearray mit Lichtleiterstruktur zur gerichteten Energiedichteerhöhung in einer aktiven Schicht eines jeden Arrayelements anzugeben, bei der das Lichtmanagement eine erhöhte Ausnutzung des einfallenden Lichts bei gleichzeitig verringertem Materialverbrauch der Schicht, in die das Licht eingekoppelt werden soll, ermöglicht. Die Lichtleiterstruktur soll ohne Ausrichtung zur aktiven Schicht herstellbar sein.

Die Aufgabe wird durch ein optoelektronisches Bauelementearray mit einer Lichtleiterstruktur zur Energiedichteerhöhung gemäß Anspruch 1 gelöst. Dabei weist die Lichtleiterstruktur zum Leiten von in das Bauelementearray einfallender elektromagnetischer Strahlung mindestens Mittel auf, die die Strahlung in laterale Wellenleitermoden koppeln. Das Bauelementearray weist weiterhin Arrayelemente auf, die benachbart zu den Mitteln, die die Strahlung in laterale Wellenleitermoden koppeln, angeordnet sind. Jedes Arrayelement weist dann mindestens eine aktive Schicht zur Ausbildung eines optoelektronischen Bauelements auf, hat laterale Abmessungen im Nano- bis Mikrometerbereich und ist mindestens von einem Matrixmaterial ummantelt. Um die in laterale Wellenleitermoden eingekoppelte elektromagnetische Strahlung in ein Arrayelement auszukoppeln, muss der Betrag des Realteils des Brechungsindex der mindestens einen aktiven Schicht größer sein als der Betrag des Realteils des Brechungsindex des das jeweilige Arrayelement ummantelnden Matrixmaterials. Dabei muss dieses Verhältnis der beiden Brechungsindizes in einem Abstand von der Lichtleiterstruktur bis mindestens der Abklinglänge der Felder der lateralen Wellenleitermoden gelten.

Eine derartige Lichtleiterstruktur gestattet ein Lichtmanagement im Nanometerbereich durch die Kombination der Kopplung der einfallenden elektromagnetischen Strahlung in laterale Wellenleitermoden und durch das gezielte Auskoppeln des Lichts in die Arrayelemente, die beliebig - außerhalb der Lichtleiterstruktur - aufgebaute optoelektronische Bauelemente sind. Durch die vorgeschlagene Lichtleiterstruktur mit definiert einzustellendem Brechungsindexkontrast der beschriebenen Schichten wird die einfallende Strahlung in den Arrayelementen konzentriert, wodurch Material der aktiven Schicht eingespart werden kann. Das Auskoppeln der in laterale Wellenleitermoden gekoppelten elektromagnetischen Strahlung erfolgt an den Stellen, wo die laterale Lichtleitung - hier durch unterschiedliche Brechungsindizes - gestört ist, somit also in die beliebig anzuordnenden Arrayelemente. Damit ist ein aufwendiges Alignment der Arrayelemente zu den Mitteln der Lichteinkopplung nicht notwendig.

Das Auskoppeln der Strahlung in die Arrayelemente, die nur einen Teil der bestrahlten Fläche des optoelektronischen Bauelementearrayss einnehmen, ist gleichbedeutend mit einer Lichtkonzentration. Diese Konzentration lässt sich über die Größe und die Dichte der Arrayelemente steuern.

Die Arrayelemente können sowohl regelmäßig als auch unregelmäßig in der Matrix angeordnet sein.

Die Formen der Arrayelemente sind nicht beschränkt, insbesondere kann ihre Kontaktfläche zu den Mitteln, die die Strahlung in laterale Wellenleitermoden koppeln, punkt- oder streifenförmig sein, aber auch unregelmäßige Formen sind möglich.

Ein Arrayelement kann in Abhängigkeit seiner Ausbildung Teil weiterer funktionaler Schichten, z. B. einer Solarzelle, einer Photodiode oder eines optoelektronischen Schaltkreises sein.

Werden die Merkmale der Erfindung realisiert, liegt die Größe der Arrayelemente typischerweise zwischen 50 nm und 6 µm, bevorzugt zwischen 500 nm und 1,5 µm, betreffend den Durchmesser bzw. äquivalente Fläche bei anderer Form, sind die Arrayelemente zueinander - von Zentrum zu Zentrum - von 500 nm bis 50 µm, bevorzugt von 2 µm bis 15 µm, für eine möglichst effiziente Nutzung der eingekoppelten Strahlung beabstandet. Die Dicke der Arrayelemente bzw. der aktiven Schicht liegt zwischen 20 nm und 6 µm, bevorzugt zwischen 50 nm und 1 µm. Die angegebenen Parameterbereiche beziehen sich auf Licht im sichtbaren Bereich und sind für andere Wellenlängen entsprechend zu skalieren.

Mit der hier beschriebenen Lichtleiterstruktur, die die einfallende Strahlung in laterale Wellenleitermoden koppelt und in die Arrayelemente auskoppelt, kann die Energiedichte im optoelektronischen Bauelement gesteuert werden. Dabei wird auch die Eigenschaft der ungerichteten Admittanz der Strahlung in den Mitteln, die sie in laterale Wellenleitermoden koppeln, ausgenutzt.

In der erfindungsgemäßen Lösung ist die Konzentration der Strahlung auf die Oberfläche der Arrayelemente getrennt von den Mitteln für die Lichtführung. Der Konzentrationsfaktor ist in der erfindungsgemäßen Vorrichtung über die Größe und den Abstand der Arrayelemente zueinander einstellbar, er kann über diese Parameter > 1 eingestellt werden. Durch diese Wirkung der beschriebenen technischen Mittel ist eine Abstimmung für die Positionierung der Arrayelemente im Fokus einer konzentrierenden Optik - wie dem Stand der Technik nach bekannt - nicht mehr notwendig, was den Herstellungsprozess vereinfacht und flexibler macht.

Die erfindungsgemäße Anordnung ist in den beschriebenen Wirkungen unabhängig von der Richtung des Einfalls der elektromagnetischen Strahlung, d.h. von der Seite der Mittel, die die Strahlung in laterale Wellenleitermoden koppeln, oder der entgegengesetzten Seite, der Seite der Arrayelemente.

Die folgenden Ausführungsformen der Erfindung betreffen die Mittel zur Einkopplung der einfallenden elektromagnetischen Strahlung in laterale Wellenleitermoden.

So können diese durch Nano- oder Mikroteilchen gebildet sein. Hierbei wird die ungerichtete Einkopplung und die Erzeugung von möglichen Plasmonenresonanzen in den Teilchen ausgenutzt. Dabei sind die Teilchen metallisch oder dielektrisch oder halbleitend und insbesondere gebildet aus einem der folgenden Materialien Ag, Au, Al, SiO₂, TiO₂, Al₂O₃ oder ZnO. Diese Aufzählung ist nicht abschließend, vielmehr kann der Fachmann weitere Materialien für die Nanopartikel einsetzen, die den Merkmalen der Erfindung genügen.

Bestehen die Mittel zur Einkopplung der einfallenden elektromagnetischen Strahlung in laterale Wellenleitermoden ausschließlich aus Nano- oder Mikroteilchen, so erfolgt der Energietransport der Wellenleitermoden in den Teilchenketten.

Zwischen den Teilchen und den Arrayelementen kann auch eine ganzflächige Schicht angeordnet werden, in der sich die lateralen Wellenleitermoden ausbreiten können.

Eine andere Ausführungsform der Erfindung betreffend ebenfalls die Mittel zur Einkopplung der einfallenden elektromagnetischen Strahlung in laterale Wellenleitermoden sieht vor, dass diese durch eine wellenleitende Schicht mit texturierter Oberfläche gebildet ist, wobei hier die Streuung der einfallenden Strahlung unter großen Winkeln sowie die ungerichtete Einkopplung ausgenutzt werden.

Ausgestaltungen der Erfindung für die Teilchen sehen Nano- oder Mikrostrukturen in ellipsoidaler Form und mit beliebiger Kontaktfläche vor oder in Form eines geometrischen Körpers mit konstantem oder sich verjüngendem Querschnitt, insbesondere ausgewählt aus den folgenden Formen: Prisma, Kegelstumpf, Pyramidenstumpf. Die Teilchen können aber auch eine Kombination verschiedener Formen bilden und dabei nicht auf die genannten Formen beschränkt sein. Im Rahmen der Erfindung liegt es auch, dass alle Teilchen gleich ausgebildet sind oder sich in Form und Material unterscheiden, gleich oder unterschiedlich zueinander beabstandet sind, d.h. eine beliebige Verteilung aufweisen. Damit kann der Wellenlängenbereich der einzukoppelnden Strahlung eingestellt werden, was ebenfalls durch unterschiedliche Materialien der Teilchen realisiert werden kann bzw. es wird die Flexibilität in der Steuerung des einzukoppelnden Wellenlängenbereichs erhöht. Die Teilchen weisen einen Durchmesser von 10 nm bis 1500 nm auf, für metallische Teilchen bevorzugt zwischen 100 nm und 300 nm und für dielektrische Teilchen zwischen 200 nm und 500 nm. Die Abstände zwischen den Teilchen betragen im Mittel bis zum Fünffachen ihres Durchmessers, bevorzugt zwischen der Hälfte und dem Einfachen ihres Durchmessers. Die Teilchen können aber auch direkt dicht benachbart sein. Diese Angaben sind wiederum in Bezug auf sichtbare Wellenlängen des einfallenden Lichts zu sehen.

Auch über die teilweise Einbettung der Teilchen in die darunterliegende wellenleitende Schicht, wie bereits erwähnt, kann der Wellenlängenbereich und die Winkelabhängigkeit der einzukoppelnden Strahlung gesteuert werden.

Wie bereits erwähnt, wird in der erfindungsgemäßen Lösung die richtungsunabhängige Absorption von Teilchen als Mittel zur Erzeugung von Wellenleitermoden ausgenutzt, um Licht aus verschiedenen Richtungen auf der gesamten Fläche des optoelektronischen Bauelements einzusammeln und dann entsprechend der Wellenleiterstruktur zu den Arrayelementen zu führen und dort zu konzentrieren.

Die Matrix kann aus Matrixbereichen mit unterschiedlichen Materialien gebildet sein. Die Arrayelemente können mindestens von einer isolierenden und/oder elektrisch passivierenden Schicht ummantelt sein. Dann können die noch verbleibenden Zwischenräumen zwischen den Arrayelementen für andere Funktionen genutzt werden. Beispielsweise können diese Zwischenräume mit metallischem Material ausgefüllt sein, das der Wärmeableitung dient. Mit diesen Ausführungsformen ist gewährleistet, dass die Arrayelemente voneinander elektrisch isolierend angeordnet sind, was insbesondere dann sinnvoll ist, wenn das Arrayelement z.B. als Solarzelle ausgebildet ist. Zur Gewährleistung der Funktionalität des optoelektronischen Bauelementearrays mit Lichtleiterstruktur ist ggf. zwischen Wellenleiterschicht und Metall eine isolierende und/oder elektrisch passivierende Schicht mit niedrigerem Brechungsindex als dem der Arrayelemente und ausreichender Dicke (größer als die Abklinglänge der Wellenleitermoden in die Richtung senkrecht zur Ausbreitungsrichtung) vorzusehen, um eine Durchkopplung des Feldes außerhalb des Arrayelements zu vermeiden und/oder die Rekombination der Ladungsträger an den Grenzflächen zu verringern.

Die folgenden Ausführungsformen betreffen die Ausgestaltung der Arrayelemente. So ist vorgesehen, dass die Arrayelemente aus unterschiedlichen Materialien mit unterschiedlichen Bandlücken gebildet sind und das optoelektronische Bauelement entsprechend der unterschiedlichen Materialien als laterales Mehrfachbauelement ausgebildet ist. Das über die Mittel zur Kopplung der einfallenden Strahlung in laterale Wellenleitermoden eingekoppelte Licht wird entsprechend der unterschiedlichen Bandlücken der Arrayelemente in diese ausgekoppelt.

Zur weiteren Verbesserung der wellenlängenselektiven Lichtauskopplung sind in einer weiteren Ausführungsform auf jedem Arrayelement weitere Teilchen angeordnet, deren Plasmonenresonanz der Bandlücke des Materials der mindestens einen aktiven Schicht des entsprechenden Arrayelements angepasst ist. Dabei befinden sich diese weiteren Teilchen eingebettet in Materialien der wellenleitenden Schicht oder der Arrayelemente mit höherem Brechungsindex als die Teilchen, die in die Wellenleitermoden einkoppeln, und weisen eine kleinere Ausdehnung auf als die Teilchen, die die Mittel zur Kopplung der einfallenden Strahlung in laterale Wellenleitermoden bilden. Die weiteren Teilchen haben einen bevorzugten Durchmesser von 40 nm bis 180 nm für metallische und von 100 nm bis 300 nm für dielektrische Teilchen im Falle von sichtbarem Licht.

Die folgenden Ausführungsformen betreffen ein optoelektronisches Bauelement, das als photoelektrische Halbleitervorrichtung mit einer Lichtleiterstruktur für Sonnenlicht ausgebildet ist, wobei die mindestens eine aktive Schicht in den Arrayelementen eine photoelektrisch aktive Halbleiterschicht ist, die wellenleitende Schicht, von deren Seite das Licht einfällt, als Frontkontaktschicht aus transparentem leitenden Material gebildet ist, sowie mindestens eine Rückkontaktschicht aufweist, die auf der dem Lichteinfall entgegengesetzten Oberfläche der photoelektrisch aktiven Halbleiterschicht angeordnet ist. Bevorzugt ist hierbei das mindestens eine Matrixmaterial, das die Arrayelemente ummantelt, elektrisch isolierend.

Das Material der photoelektrisch, speziell einer photovoltaisch aktiven Schicht kann ausgewählt sein aus folgenden Materialien: Si oder III-V-Verbindungen, wie beispielsweise GaAs, oder aus einem Material der Gruppe der Chalkopyrite, der Perovskite oder der Kesterite oder aus einem organischen Material. Beispielhaft genannt seien hier Cu(In,Ga)(S,Se)₂ oder Ag(In,Ga)Se₂ oder Cu(In,Al)Se₂. Diese Aufzählung ist nicht abschließend, vielmehr kann der Fachmann weitere Halbleitermaterialien einsetzen, die den Merkmalen der Erfindung genügen.

Mit der nächsten Ausführungsform der Erfindung kann das Spektrum aus dem einfallenden Licht selektiv bei der Einkopplung in die Teilchen ausgewählt und in Arrayelemente mit aktiver photoelektrischer Schicht - also konzentriert - eingekoppelt werden. Dafür ist die Frontkontaktschicht streifenförmig ausgebildet, die Teilchen sind linienförmig auf den Frontkontaktstreifen in deren Längsausdehnung angeordnet, und die Teilchen unterscheiden sich von einem Frontkontaktstreifen zum benachbarten in Form, Größe oder Material. Außerdem ist die jedem Frontkontaktstreifen zugeordnete photovoltaisch aktive Schicht in jedem Arrayelement in ihrer Bandlücke den Teilchen angepasst. Der Abstand benachbarter Frontkontaktstreifen mit unterschiedlichen Teilchen ist dabei so zu wählen, dass sich die Extinktionsquerschnitte der auf ihnen befindlichen Teilchen mindestens überlappen.

Auf der dem Lichteinfall zugewandten Fläche der Rückkontaktschicht ist eine Reflexionsschicht angeordnet, deren dem Lichteinfall zugewandte Fläche glatt oder texturiert, beispielsweise porös oder rau, ist oder zusätzlich reflektierende Teilchen aufweist. Diese Teilchen weisen ebensolche Eigenschaften auf, wie sie bereits zu den Teilchen beschrieben sind, die die Einkopplung der einfallenden Strahlung in laterale Wellenleitermoden bewirken, sowie eine Kopplung dieser Wellenleitermoden in die dem Lichteinfall entgegengesetzte Fläche der Arrayelemente.

Die Erfindung wird in einem Ausführungsbeispiel für eine Solarzelle und eine laterale Mehrfach-Solarzelle anhand von Figuren näher erläutert.

Die Figuren zeigen
- Fig. 1:: schematisch die Lichtführung in einer erfindungsgemäßen Ausführungsform der Erfindung, dargestellt ist ein als Teil einer Solarzelle ausgebildetes Arrayelement, und
- Fig: 2:: schematisch die Lichtführung in einer anderen erfindungsgemäßen Ausführungsform der Erfindung, einer lateralen Mehrfach-Solarzelle.

In Fig. 1 sind als Teile einer Konzentrator-Solarzelle dargestellt Nanoteilchen **1,** die sich auf einer als Frontkontaktschicht **3** ausgebildeten wellenleitenden Schicht aus einem leitenden Metalloxid, von Luft **2** (n = 1) umgeben, befinden. Das einfallende Sonnenlicht trifft zunächst auf die Nanoteilchen **1** aus SiO₂, deren Größe 400 nm (Durchmesser) und ihr Abstand 625 nm (Mitte zu Mitte) beträgt. Der Brechungsindex des leitenden Metalloxids beträgt n = 1,8. Benachbart zur Oberfläche der dem Lichteinfall abgewandten Seite der Frontkontaktschicht **3** ist ein Array aus Arrayelementen **4** (in Figur 1 ist nur ein Element dargestellt) angeordnet. Die Arrayelemente **4,** gebildet aus CIGSe (n = 2,8) als photoaktive Schicht, sind in einer Matrix **5** aus SiO₂ (n = 1,5) angeordnet und bedecken 6 % der Gesamtfläche des Bauelements. Das auf die Nanoteilchen **1** auftreffende Licht wird in den Nanoteilchen **1** aufgenommen und gemäß ihrer photonischen/plasmonischen Eigenschaften in die als Wellenleiterschicht ausgebildete Frontkontaktschicht **3** eingekoppelt. Die beschriebene Anordnung erfüllt die Bedingungen einer Lichtleiterstruktur zum Leiten von in das Bauelementearray einfallender elektromagnetischer Strahlung, die mindestens Mittel aufweist, die die Strahlung in laterale Wellenleitermoden koppelt, da die Brechungsindizes der Umgebung der Nanoteilchen **1** und der Matrix 5 kleiner sind als der Brechungsindex der Frontkontaktschicht **3** und somit das Licht in Wellenleitermoden der Frontkontaktschichtschicht 3 eingekoppelt und in dieser weitergeleitet wird. Da weiterhin der Brechungsindex der halbleitenden Arrayelemente **4** größer ist als der der Frontkontaktschicht **3** und der die Arrayelemente **4** umgebenden Matrix **5** wird das Licht aus der wellenleitenden Frontkontaktschicht **3** in die Arrayelemente **4** ausgekoppelt. Damit ist eine Konzentratorwirkung erreicht, die zur Effizienzerhöhung der Solarzelle führt. Der Vollständigkeit halber sei erwähnt, dass für das Beispiel einer Solarzelle nun noch mindestens ein Rückkontakt 7, z.B. ein flächiger, anzuordnen ist.

Die in Fig. 2 schematisch dargestellten Elemente sind Teile einer lateralen Mehrfachsolarzelle. Neben den bereits zu Figur 1 erläuterten Bestandteilen einer Solarzelle sind in Fig. 2 Arrayelemente **4.1, 4.2, 4.3** mit photoaktiven Schichten unterschiedlicher Bandlücken dargestellt sowie weitere Nanoteilchen **6.1, 6.2, 6.3** auf diesen Arrayelementen **4.1, 4.2, 4.3** zur Verbesserung des Lichtmanagements in einem solchen lateralen Mehrfachbauelement. Diese weiteren Nanopartikel sind gemäß ihrer Resonanz passend zur Bandlücke des darunterliegenden Materials der aktiven Halbleiterschicht ausgewählt und sind kleiner als die zuerst erwähnten Nanopartikel, die auf der der lichteinfallenden Oberfläche der wellenleitenden Schicht angeordnet sind. Beispiele für die Teilchen **6.1, 6.2, 6.3** wären Ag-Teilchen mit Durchmessern von 60 nm und von 100 nm sowie Au-Teilchen mit Durchmessern von 100 nm. Somit kann die Auskopplung des korrekten Wellenlängenbereichs von der wellenleitenden Schicht **3** über die weiteren Nanopartikel **6.1, 6.2, 6.3** in das jeweils passende Arrayelement **4.1, 4.2, 4.3** gewährleistet werden. Mit dieser Ausführungsform eines Mehrfachbauelements ist die Führung von Licht ausgewählter Wellenlängenbereiche in definierte Gebiete der bestrahlten Fläche verbessert.

## Patentansprüche

1. Optoelektronisches Bauelementearray mit Lichtleiterstruktur, wobei
- die Lichtleiterstruktur zum Leiten von in das Bauelementearray einfallender elektromagnetischer Strahlung mindestens Mittel aufweist, die die Strahlung in laterale Wellenleitermoden koppelt, und
- Arrayelemente (4, 4.1, 4.2, 4.3) benachbart zu den Mitteln angeordnet sind, die die Strahlung in horizontale Wellenleitermoden koppeln, und jedes Arrayelement (4, 4.1, 4.2, 4.3) mindestens eine aktive Schicht zur Ausbildung eines optoelektronischen Bauelements aufweist, und die Arrayelemente (4, 4.1, 4.2, 4.3) laterale Abmessungen im Nano- bis Mikrometerbereich aufweisen sowie mindestens von wenigstens einem Matrixmaterial (5) ummantelt sind, und
- ein Betrag des Realteils des Brechungsindex der mindestens einen aktiven Schicht größer ist als der Betrag des Realteils des Brechungsindex des das jeweilige Arrayelement (4, 4.1, 4.2, 4.3) ummantelnden Matrixmaterials (5), wobei dieses Verhältnis der beiden Brechungsindizes in einem Abstand von der Lichtleiterstruktur bis mindestens der Abklinglänge der Felder der lateralen Wellenleitermoden gilt.

2. Optoelektronisches Bauelementearray nach Anspruch 1,
**dadurch gekennzeichnet, dass**
die Mittel zur Einkopplung der einfallenden Strahlung in laterale Wellenleitermoden Nano- oder Mikroteilchen (1) sind.

3. Optoelektronisches Bauelementearray nach Anspruch 2,
**dadurch gekennzeichnet, dass**
zwischen den Nano- und Mikroteilchen (1) und den Arrayelementen (4, 4.1, 4.2, 4.3) eine wellenleitende Schicht ganzflächig angeordnet ist.

4. Optoelektronisches Bauelementearray nach Anspruch 3,
**dadurch gekennzeichnet, dass**
die Teilchen (1) teilweise in die wellenleitende Schicht eingebettet sind.

5. Optoelektronisches Bauelementearray nach Anspruch 1,
**dadurch gekennzeichnet, dass**
das Mittel zur Einkopplung der einfallenden Strahlung in laterale Wellenleitermoden eine wellenleitende Schicht mit texturierter Oberfläche ist.

6. Optoelektronisches Bauelementearray nach Anspruch 1,
**dadurch gekennzeichnet, dass**
die mindestens eine aktive Schicht in jedem Arrayelement (4, 4.1, 4.2, 4.3) aus in unterschiedlichen Spektralbereichen aktiven Materialien gebildet und das optoelektronische Bauelementearray als laterales Mehrfachbauelement ausgebildet ist.

7. Optoelektronisches Bauelementearray nach mindestens einem der vorangehenden Ansprüche,
**dadurch gekennzeichnet, dass**
auf jedem Arrayelement (4.1, 4.2, 4.3) weitere Teilchen (6.1, 6.2, 6.3) angeordnet sind, deren Plasmonenresonanz der Bandlücke des Materials der mindestens einen aktiven Schicht des entsprechenden Arrayelements (4, 4.1, 4.2, 4.3) angepasst ist.

8. Optoelektronisches Bauelementearray nach mindestens einem der vorangehenden Ansprüche,
**dadurch gekennzeichnet, dass**
auf der entgegengesetzten Fläche der Arrayelemente (4, 4.1, 4.2, 4.3) und der ummantelnden Matrix (5), auf der die Mittel, die die Strahlung in laterale Wellenleitermoden koppeln, angeordnet sind, eine Reflexionsschicht angeordnet ist.

9. Optoelektronisches Bauelementearray nach Anspruch 8,
**dadurch gekennzeichnet, dass**
die Reflexionsschicht texturiert ist.

10. Optoelektronisches Bauelementearray nach Anspruch 8,
**dadurch gekennzeichnet, dass**
die Reflexionsschicht zusätzlich Nano- oder Mikroteilchen aufweist.

11. Optoelektronisches Bauelementearray nach mindestens einem der Ansprüche 3 oder 10,
**dadurch gekennzeichnet, dass**
die Teilchen Nano- oder Mikrostrukturen in ellipsoidaler Form und mit beliebiger Kontaktfläche sind.

12. Optoelektronisches Bauelementearray nach mindestens einem der Ansprüche 3 oder 10,
**dadurch gekennzeichnet, dass**
die Teilchen Nano- oder Mikrostrukturen in Form eines geometrischen Körpers mit konstantem oder sich verjüngendem Querschnitt sind, insbesondere ausgewählt aus den folgenden Formen: Prisma, Kegelstumpf, Pyramidenstumpf.

13. Optoelektronisches Bauelementearray nach Anspruch 1,
**dadurch gekennzeichnet, dass**
das optoelektronische Bauelementearray als photoelektrische Halbleitervorrichtung mit einer Lichtleiterstruktur für Sonnenlicht ausgebildet ist, wobei die mindestens eine aktive Schicht in den Arrayelementen (4, 4.1, 4.2, 4.3) eine photoelektrisch aktive Halbleiterschicht ist, die wellenleitende Schicht als Frontkontaktschicht (3) aus transparentem leitenden Material gebildet ist, und mindestens noch eine Rückkontaktschicht (7) vorgesehen ist.

14. Optoelektronisches Bauelementearray nach Anspruch 13,
**dadurch gekennzeichnet, dass**
das mindestens eine Matrixmaterial (5), das die Arrayelemente (4, 4.1, 4.2, 4.3) ummantelt, isolierend und/oder elektrisch passivierend ist.

15. Optoelektronisches Bauelementearray nach Anspruch 13,
**dadurch gekennzeichnet, dass**
die Frontkontaktschicht streifenförmig ausgebildet ist, die Teilchen linienförmig auf den Frontkontaktstreifen in deren Längsausdehnung angeordnet sind und sich die Teilchen von einem Frontkontaktstreifen zum nächsten in Form, Größe oder Material unterscheiden, benachbarte Frontkontaktstreifen mit unterschiedlichen Teilchen derart beabstandet sind, dass sich die Extinktionsquerschnitte ihrer Teilchen mindestens überlappen, sowie die jedem Frontkontaktstreifen zugeordnete photovoltaisch aktive Schicht in jedem Arrayelement in ihrer Bandlücke den Teilchen angepasst ist.
